# EUROPEAN PATENT SPECIFICATION

(11) **EP 0 691 690 B1**
(45) Date of publication and mention of the grant of the patent: **13.05.1998**
(21) Application number: 95401601.0
(22) Date of filing: 04.07.1995
(51) Int. Cl.: H01L 39/14

(54) **Superconducting device having a superconducting channel formed of oxide superconductor material**
Supraleitendes Bauelement mit einem supraleitenden Kanal aus supraleitendem Oxidmaterial
Dispositif supraconducteur à canal supraconducteur en oxyde supraconducteur

(30) Priority: 04.07.1994 JP 174757/94
(43) Date of publication of application: 10.01.1996
(73) Proprietor: Sumitomo Electric Industries, Ltd., Osaka 541 (JP)
(72) Inventor: Nakamura, Takao, F-75116 Paris (FR); IIyama, Michitomo, F-75116 Paris (FR)
(74) Representative: Ballot, Paul Denis Jacques

(56) References cited:
- EP-A- 0 354 804
- EP-A- 0 484 253
- EP-A- 0 546 959
- EP-A- 0 551 033

## Description

### Background of the Invention

### Field of the invention

The present invention relates to a superconducting field effect device. More specifically the present invention relates to a field effect transistor type superconducting device having a superconducting channel, superconducting source region and a superconducting drain region formed of oxide superconductor thin films, and a gate electrode on a gate insulator which is disposed on the superconducting channel, in which superconducting current flowing through the superconducting channel can be completely cut off.

### Description of related art

Devices which utilize superconducting phenomena operate rapidly with low power consumption so that they have higher performance than conventional semiconductor devices. Particularly, by using an oxide superconductor material which has been recently advanced in study, it is possible to produce a superconducting device which operates at relatively high temperature.

One of the most important three-terminal superconducting devices is a field effect transistor type superconducting device (abbreviated as super-FET hereinafter) having a channel of a superconductor formed between a source and a drain. In this superconducting device, a current flowing through the superconducting channel is controlled by a signal voltage applied to a gate formed above the superconducting channel.

The super-FET mentioned above is a voltage controlled device which is capable of isolating output signals from input ones and of having a well defined gain. In addition, it has a large current capability, and fine processing which is difficult to conduct is not needed to product this type of super-FET.

In the above super-FET, both of the superconducting channel and the gate insulating layer should have an extremely thin thickness to obtain a complete ON/OFF operation by a signal voltage of a few volts applied to the gate electrode. For example, the superconducting channel formed of an oxide superconductor material should have a thickness of five nanometers or less and the gate insulating layer should have a thickness of ten to fifteen nanometers or more to prevent a tunnel current, but it should be as thin as possible.

For excellent properties of the super-FET, the thin superconducting channel should be formed of an oxide superconductor thin film having high crystallinity and good characteristics. In order to realize this thin superconducting channel, a buffer layer of an oxide having a crystal structure the same as that of an oxide superconductor and lattice parameters similar to those of the oxide superconductor is formed on a substrate and the oxide superconductor thin film of the superconducting channel is deposited on the buffer layer.

The buffer layer prevents interdiffusion between the substrate and the superconducting channel and cancels inconsistencies of lattice parameters. Therefore, an oxide superconductor thin film well grows second dimensionally on the buffer layer.

For example, the buffer layer is formed of Pr₁Ba₂Cu₃O_{7-y} when Y₁Ba₂Cu₃O₇₋ₓ oxide superconductor is used for the superconducting channel (see, for example, patent application EP-A-0 546 959).

However, Pr₁Ba₂Cu₃O_{7-y} may have extremely small resistivity at low temperatures by some post-treatment. In addition, if some oxide superconductors, such as Y₁Ba₂Cu₃O₇₋ₓ oxide superconductor, are disposed in contact with a Pr₁Ba₂Cu₃O_{7-y} layer, superconducting current may flow through the Pr₁Ba₂Cu₃O_{7-y} layer due to the long-range proximity effect.

Therefore, in a super-FET having superconducting channel of a Y₁Ba₂CU₃O₇₋ₓ oxide superconductor thin film formed on a Pr₁Ba₂Cu₃O_{7-y} buffer layer, a portion of a surface of the Pr₁Ba₂Cu₃O_{7-y} buffer layer falls in superconducting state when a depletion layer reaches the Pr₁Ba₂Cu₃O_{7-y} buffer layer, which is generated in the superconducting channel by a signal voltage supplied to the gate electrode. Namely, superconducting current flows between the superconducting source region and the superconducting drain region through the Pr₁Ba₂Cu₃O_{7-y} buffer layer even when the gate is closed, so that it is difficult to realize complete ON/OFF operation.

### Summary of the Invention

Accordingly, it is an object of the present invention to provide a novel FET type superconducting device having a superconducting channel of an extremely thin oxide superconductor film, which have overcome the above mentioned defects of the conventional ones.

The above and other objects of the present invention are achieved in accordance with the present invention by a superconducting device as claimed in claim 1. The device comprises a substrate having a principal surface, a thin superconducting channel forrned of an oxide superconductor over the principal surface of the substrate, a superconducting source region and a superconducting drain region formed of an oxide superconductor over the principal surface of the substrate at the both ends of the superconducting channel which connects the superconducting source region and the superconducting drain region, so that superconducting current can flow through the superconducting channel between the superconducting source region and the superconducting drain region, a gate electrode on a gate insulator disposed on the superconducting channel for controlling the superconducting current flowing through the superconducting channel by a signal voltage applied to the gate electrode, and a first dielectric buffer layer under the superconducting source region, superconducting channel and superconducting drain region, by which leak current is prevented when the superconducting channel is closed.

In one preferred embodiment, the first dielectric buffer layer has a thickness of 10 to 30 nanometers. If the first dielectric buffer layer is too thin, tunnel current may pass through the dielectric layer to a lower layer when the superconducting channel is closed. Therefore, it is impossible to prevent leak current completely. On the contrary, if the first dielectric buffer layer is too thick, it is difficult to form a planar layer. In this case, the superconducting channel, the superconducting source region and the superconducting drain region may be seriously affected by unevenness.

According to the present invention, the first dielectric buffer layer is formed of BaₓSr₁₋ₓTiO₃ (0≤ x ≤1). BaₓSr₁₋ₓTiO₃ is a dielectric material through which no superconducting current flows by the long-range proximity effect. Therefore, superconducting current flowing between the superconducting source and drain regions can completely shut by an appropriate gate voltage in the super-FET according to the present invention. BaₓSr₁₋ₓTiO₃ has lattice parameters similar to those of an oxide superconductor so that an oxide superconductor thin film epitaxially grows on a BaₓSr₁₋ₓTiO₃ layer. In addition, little mutual diffusion occurs between an oxide superconductor and BaₓSr₁₋ₓTiO₃ which allows an oxide superconductor thin film having an excellent superconducting properties grow on a BaₓSr₁₋ₓTiO₃ layer.

In the superconducting device in accordance with the present invention, a second buffer layer of a non-superconducting oxide is disposed between the first dielectric buffer layer and the principal surface of the substrate. The non-superconducting oxide layer has a similar crystal structure to that of an oxide superconductor. The second buffer layer prevents mutual diffusion between the first dielectric buffer layer and the substrate so that the first dielectric buffer layer has high crystallinity and high dielectric constant. This contributes improvement of crystallinity and properties of the superconducting channel. For this purpose, the second buffer layer preferably has a thickness of 10 to 30 nanometers.

The above non-superconducting oxide layer is formed of a Pr₁Ba₂Cu₃O_{7-y} oxide. Pr₁Ba₂Cu₃O_{7-y} has almost the same crystal lattice structure as that of an oxide superconductor.

In a preferred embodiment, the oxide superconductor is formed of high-T_{c} (high critical temperature) oxide superconductor, particularly, formed of a high-T_{c} copper-oxide type compound oxide superconductor for example a Y-Ba-Cu-O compound oxide superconductor material, a Bi-Sr-Ca-Cu-O compound oxide superconductor material, and a T1-Ba-Ca-Cu-O compound oxide superconductor material.

In addition, the substrate can be formed of an insulating substrate, preferably an oxide single crystalline substrate such as MgO, SrTiO₃, YSZ, etc. These substrate materials are very effective in forming or growing a crystalline film having a well defined crystalline orientation.

However, in one preferred embodiment, the super-FET can be formed on a substrate of a semiconductor material, if an appropriate insulating buffer layer is deposited thereon. For example, the buffer layer on the semiconductor substrate can be formed of a double-layer coating formed of a MgAl₂O₄ layer and a BaTiO₃ layer if silicon is used as a substrate.

The above and other objects, features and advantages of the present invention will be apparent from the following description of preferred embodiments of the invention with reference to the accompanying drawings.

### Brief Description of the Drawings

Figures 1A to 1F are diagrammatic sectional views for illustrating an embodiment of the process for manufacturing the super-FET in accordance with the present invention;
Figure 2A shows graphs of drain-source current against gate voltages of the super-FET in accordance with the present invention and a conventional super-FET; and
Figure 2B shows graphs of drain-source current against drain-source voltage of the super-FETs in accordance with the present invention.

### Description of the Preferred embodiments

### Embodiment 1

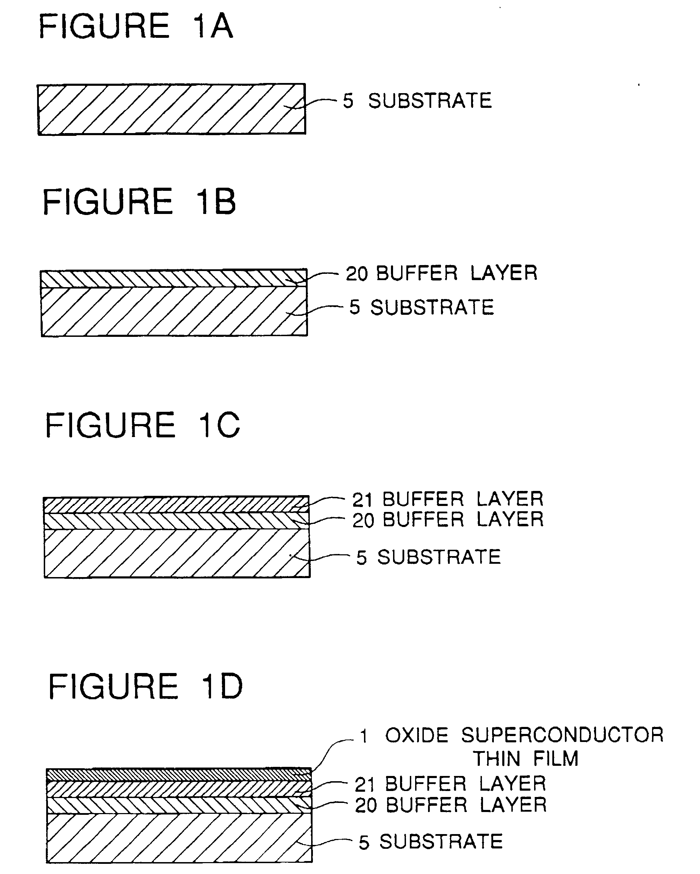

Referring to Figures 1A to 1F, a process for manufacturing the super-FET in accordance with the present invention will be described.

On a SrTiO₃ (100) single crystalline substrate 5 as shown in Figure 1A, a c-axis orientated Pr₁Ba₂Cu₃O_{7-y} oxide buffer layer 20 is deposited by a reactive co-evaporation, as shown in Figure 1B. The *c*-axis orientated Pr₁Ba₂Cu₃O_{7-y} oxide buffer layer 20 is formed of a Pr₁Ba₂Cu₃O_{7-y} oxide crystal having c-axes perpendicular to the substrate. The Pr₁Ba₂Cu₃O_{7-y} oxide buffer layer 20 may also be prepared by an MBE (Molecular Beam Epitaxy). A condition of forming the Pr₁Ba₂Cu₃O_{7-y} oxide buffer layer 20 by a reactive co-evaporation is as follows:

| | | |
|---|---|---|
| Substrate temperature | | 700 °C |
| Pressure | | 1,333 × 10⁻³ Pa (1 × 10⁻⁵ Torr) (near the substrate) (O₂ including 70 vol. % O₃ or more) |
| Evaporation source | Pr: | 1225 °C |
| and its crucible temperature | Ba: | 600 °C |
| | Cu: | 1040 °C |
| Film thickness | | 10 nanometers |

The Pr₁Ba₂Cu₃O_{7-y} buffer layer 20 preferably has a thickness of 10 to 30 nanometers, on which a BaₓSri₁₋ₓTiO₃ layer of high crystallinity and high dielectric properties can be deposited.

Then, switching evaporation sources to barium and titanium, a BaTiO₃ buffer layer 21 is successively deposited on the Pr₁Ba₂Cu₃O_{7-y} buffer layer 20 by a reactive co-evaporation, as shown in Figure 1C. A condition of forming the BaTiO₃ buffer layer 21 by a reactive co-evaporation is as follows:

| | | |
|---|---|---|
| Substrate temperature | | 500 °C |
| Pressure | | 1,333 × 10⁻³ Pa (1 × 10⁻⁵ Torr) (near the substrate) (O₂ including 70 vol. % O₃ or more) |
| Evaporation source and its crucible temperature | Ba: | 600 °C |
| | Ti: | 1500 °C |
| Film thickness | | 30 nanometers |

Thereafter, switching evaporation sources to yttrium, barium and copper, a Y₁Ba₂CU₃O₇₋ₓ oxide superconductor thin film 1 is successively deposited on the BaTiO₃ buffer layer 21 by a reactive co-evaporation, as shown in Figure 1D. The Y₁Ba₂Cu₃O₇₋ₓ oxide superconductor thin film 1 is grown so as to have a thickness of 5 nanometers or less which is suitable for a superconducting channel of a super-FET. A condition of forming the Y₁Ba₂Cu₃O₇₋ₓ oxide superconductor thin film 1 by a reactive co-evaporation is as follows:

| | | |
|---|---|---|
| Substrate temperature | | 700 °C |
| Pressure | | 1,333 × 10⁻³ Pa (1 × 10⁻⁵ Torr) (near the substrate) (O₂ including 70 vol. % O₃ or more) |
| Evaporation source and its crucible temperature | Y: | 1220 °C |
| | Ba: | 620 °C |
| | Cu: | 1000 °C |
| Film thickness | | 5 nanometers |

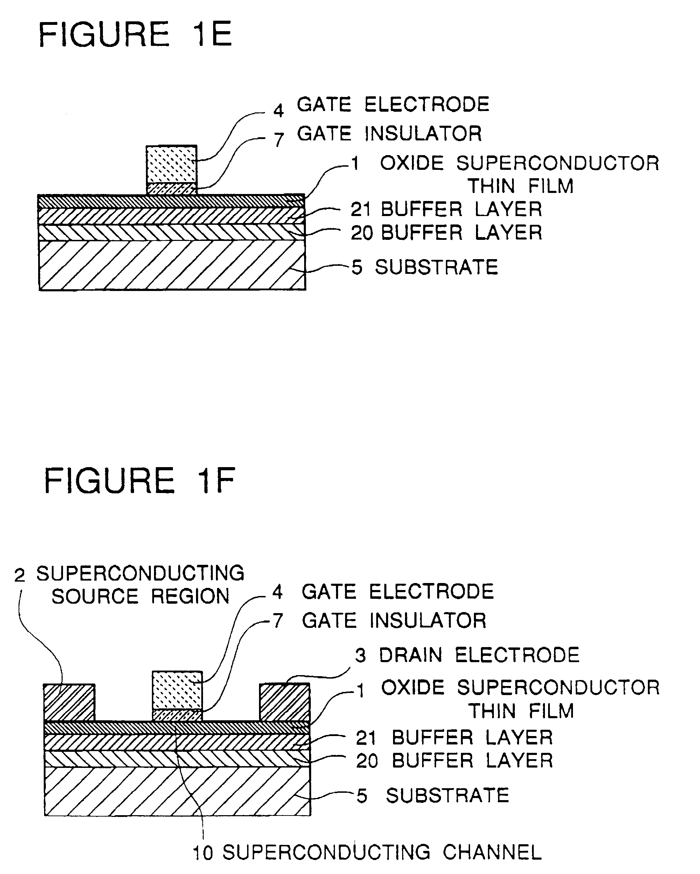

Then, as shown in Figure 1E, an gate insulating layer 7 of SrTiO₃ is formed on a center portion of the Y₁Ba₂Cu₃O₇₋ₓ oxide superconductor thin film 1 by a reactive co-evaporation and a gate electrode 4 is formed of Au on the gate insulating layer 7 by a vacuum evaporation. A portion of the Y₁Ba₂Cu₃O₇₋ₓ oxide superconductor thin film 1 under the gate insulating layer 7 becomes a superconducting channel. The gate insulating layer 7 should have a thickness of 10 nanometers or more so as to prevent tunnel current. However, if the gate insulating layer 7 has a too large thickness, higher signal voltages are required to modulate and control superconducting current flowing through the superconducting channel. Therefore, the gate insulating layer 7 should have a thickness of 100 nanometers or less. A condition of forming the SrTiO₃ gate insulating layer 7 by a reactive co-evaporation is as follows:

| | | |
|---|---|---|
| Substrate temperature | | 500 °C |
| Pressure | | 3,999 × 10⁻³ Pa (3 × 10⁻⁵ Torr) (near the substrate) (O₂ including 70 vol. % O₃ or more) |
| Evaporation source and its crucible temperature | Sr: | 600 °C |
| | Ti: | 1500 °C |
| Film thickness | | 15 nanometers |

The gate insulating layer 7 can be formed of MgO, Si₃N₄ or BaₓSr₁₋ₓTiO₃ (0 ≤ x ≤ 1). The gate electrode 4 can also be formed of a noble metal such as Pt, Ag, polycrystalline silicon or an oxide superconductor.

Finally, as shown in Figure 1F, an oxide superconductor thin film is deposited on portions of the Y₁Ba₂Cu₃O₇₋ₓ oxide superconductor thin film 1 at the both sides of the gate electrode 4 by a reactive evaporation so as to form a superconducting source region 2 and superconducting drain region 3. The superconducting source region 2 and superconducting drain region 3 preferably have a thickness of 100 nanometers or more which is sufficient to form contacts on them. In addition, since the superconducting channel 10 is connected to lower portions of the superconducting source region 2 and superconducting drain region 3, it is preferable to form them of an α-axis orientated Y₁Ba₂Cu₃O₇₋ₓ oxide superconductor thin film through which large superconducting current can flow in a direction perpendicular to the film surface. A condition of forming an α-axis orientated Y₁Ba₂Cu₃O₇₋ₓ oxide superconductor thin film for the superconducting source region 2 and superconducting drain region 3 by a reactive co-evaporation is as follows:

| | | |
|---|---|---|
| Substrate temperature | | 650 °C |
| Pressure | | 3,999 × 10⁻³ Pa (3 × 10⁻⁵ Torr) (near the substrate) (O₂ including 70 vol. % O₃ or more) |
| Evaporation source and its crucible temperature | Y: | 1220 °C |
| | Ba: | 620 °C |
| | Cu: | 1000 °C |
| Film thickness | | 300 nanometers |

A metal source electrode and drain electrode are formed on the superconducting source region 2 and superconducting drain region 3, if necessary. With this, the super-FET in accordance with the present invention is completed.

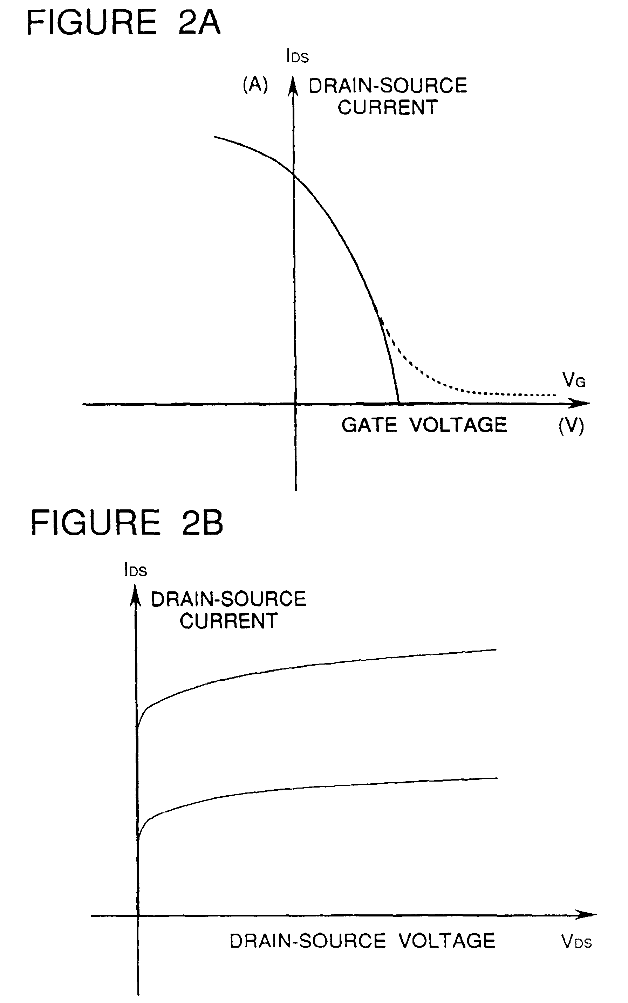

Properties of the super-FET in accordance with the present invention manufactured as mentioned above were measured and compared with a conventional super-FET which did not have a BaTiO₃ buffer layer. The results are shown in Figures 2A and 2B. Figure 2A shows a graph of superconducting current I_{DS} flowing between the superconducting source and drain regions against signal voltage V_{G} applied to the gate electrode of the super-FET. The characteristics of the super-FET in accordance with the present invention are shown by a solid line and of the conventional super-FET are shown by a broken line. As shown in Figure 2A, a little superconducting current I_{DS} flowed in the conventional super-FET, however high voltage V_{G} was applied to the gate electrode. On the other hand, in the super-FET in accordance with the present invention, superconducting current I_{DS} was completely shut when a little high voltage V_{G} was applied to the gate electrode. Therefore, the super-FET in accordance with the present invention has small loss when the superconducting current is shut so as to have small consumption.

Figure 2B shows graphs of drain-source current against drain-source voltage of different super-FETs in accordance with the present invention. As shown in Figure 2B, the super-FETs in accordance with the present invention had ideal current-voltage characteristics between the superconducting source and drain region.

In this embodiment, only one super-FET according to the present invention has been described. However, the present invention is not limited to this embodiment. For example, the superconducting source region and the superconducting drain region may be gently connected to the superconducting channel so that superconducting current efficiently flows from the superconducting source region into the extremely thin superconducting channel and efficiently flows from the extremely thin superconducting channel to the superconducting drain region. In addition, the superconducting channel, the gate insulating layer and the gate electrode may have configurations so that they are self-aligned in the manufacturing process.

### Embodiment 2

A process for manufacturing the super-FET of different type in accordance with the present invention will be described. The super-FET of this embodiment has a buffer layer 21 formed of Ba_{0.3}Sr_{0.7}TiO₃. The other parts of the super-FET are the same as those of the super-FET of Embodiment 1. Therefore, the differences will be mainly described hereinafter.

On a SrTiO₃ (100) single crystalline substrate 5 as shown in Figure 1A, a *c*-axis orientated Pr₁Ba₂Cu₃O_{7-y} oxide buffer layer 20 having a thickness of 10 nanometers is deposited by a reactive co-evaporation, as shown in Figure 1B under a condition the same as Embodiment 1.

Then, switching evaporation sources to barium, strontium and titanium, a Ba_{0.3}Sr_{0.7}TiO₃ buffer layer 21 is successively deposited on the Pr₁Ba₂Cu₃O_{7-y} buffer layer 20 by a reactive co-evaporation, as shown in Figure 1C. A condition of forming the Ba_{0.3}Sr_{0.7}TiO₃ buffer layer 21 by a reactive co-evaporation is as follows:

| | | |
|---|---|---|
| Substrate temperature | | 500 °C |
| Pressure | | 1,333 × 10⁻³ Pa (1 × 10⁻⁵ Torr) (near the substrate) (O₂ including 70 vol. % O₃ or more) |
| Evaporation source and its crucible temperature | Ba: | 580 °C |
| | Sr: | 590 °C |
| | Ti: | 1500 °C |
| Film thickness | | 30 nanometers |

Thereafter, switching evaporation sources to yttrium, barium and copper, a Y₁Ba₂Cu₃O₇₋ₓ oxide superconductor thin film 1 is successively deposited on the Ba_{0.3}Sr_{0.7}TiO₃ buffer layer 21 by a reactive co-evaporation, as shown in Figure 1D. The Y₁Ba₂Cu₃O₇₋ₓ oxide superconductor thin film 1 is grown so as to have a thickness of 5 nanometers or less which is suitable for a superconducting channel of a super-FET. A condition of forming the Y₁Ba₂Cu₃O₇₋ₓ oxide superconductor thin film 1 is the same as the Embodiment 1.

Then, as shown in Figure 1E, an gate insulating layer 7 of SrTiO₃ having a thickness of 15 nanometers is formed on a center portion of the Y₁Ba₂Cu₃O₇₋ₓ oxide superconductor thin film 1 by a reactive co-evaporation and a gate electrode 4 is formed of Au on the gate insulating layer 7 by a vacuum evaporation. A portion of the Y₁Ba₂Cu₃O₇₋ₓ oxide superconductor thin film 1 under the gate insulating layer 7 becomes a superconducting channel. The gate insulating layer 7 should have a thickness of 10 nanometers or more so as to prevent tunnel current. However, if the gate insulating layer 7 has a too large thickness, higher signal voltages are required to modulate and control superconducting current flowing through the superconducting channel. Therefore, the gate insulating layer 7 should have a thickness of 100 nanometers or less. A condition of forming the SrTiO₃ gate insulating layer 7 by a reactive co-evaporation is the same as Embodiment 1.

The gate insulating layer 7 can be formed of MgO, Si₃N₄ or BaₓSr₁₋ₓTiO₃ (0 ≤ x ≤ 1). The gate electrode 4 can also be formed of a noble metal such as Pt, Ag, polycrystalline silicon or an oxide superconductor.

Finally, as shown in Figure 1F, an oxide superconductor thin film is deposited on portions of the Y₁Ba₂Cu₃O₇₋ₓ oxide superconductor thin film 1 at the both sides of the gate electrode 4 by a reactive evaporation so as to form a superconducting source region 2 and superconducting drain region 3.

Properties of the super-FET of this embodiment manufactured as mentioned above were measured. In the super-FET of this embodiment, superconducting current I_{DS} was completely shut when a little high voltage V_{G} was applied to the gate electrode. Therefore, the super-FET in accordance with the present invention has small loss when the superconducting current is shut so as to have small consumption.

In addition, it was clear that the super-FETs of this embodiment had ideal current-voltage characteristics between the superconducting source and drain region.

In this embodiment, only one super-FET according to the present invention has been described. However, the present invention is not limited to this embodiment. For example, the superconducting source region and the superconducting drain region may be gently connected to the superconducting channel so that superconducting current efficiently flows from the superconducting source region into the extremely thin superconducting channel and efficiently flows from the extremely thin superconducting channel to the superconducting drain region. In addition, the superconducting channel, the gate insulating layer and the gate electrode may have configurations so that they are self-aligned in the manufacturing process.

### Embodiment 3

A process for manufacturing the super-FET of another type in accordance with the present invention will be described. The super-FET of this embodiment has a substrate formed of Y₁Ba₂Cu₃O₇₋ₓ oxide superconductor single crystal. The other parts of the super-FET are the same as those of the super-FET of Embodiment 2. Therefore, the differences will be mainly described hereinafter.

On a (001) plane of a Y₁Ba₂Cu₃O₇₋ₓ oxide superconductor single crystalline substrate 5 as shown in Figure 1A, a *c*-axis orientated Pr₁Ba₂Cu₃O_{7-y} oxide buffer layer 20 having a thickness of 10 nanometers is deposited by a reactive co-evaporation, as shown in Figure 1B under a condition the same as Embodiment 1. The Y₁Ba₂Cu₃O₇₋ₓ oxide superconductor single crystalline substrate 5 was prepared by a melting method in which a Y₁Ba₂Cu₃O₇₋ₓ oxide superconductor single crystal was grown from the melt. The Y₁Ba₂Cu₃O₇₋ₓ oxide superconductor single crystalline substrate 5 had dimensions of 5 millimeters square and was 0.5 millimeters thick.

Then, switching evaporation sources to barium, strontium and titanium, a Ba_{0.3}Sr_{0.7}TiO₃ buffer layer 21 is successively deposited on the Pr₁Ba₂Cu₃O_{7-y} buffer layer 20 by a reactive co-evaporation, as shown in Figure 1C. A condition of forming the Ba_{0.3}Sr_{0.7}TiO₃ buffer layer 21 having a thickness of 30 nanometers by a reactive co-evaporation is the same as Embodiment 2.

Thereafter, switching evaporation sources to yttrium, barium and copper, a Y₁Ba₂Cu₃O₇₋ₓ oxide superconductor thin film 1 is successively deposited on the Ba_{0.3}Sr_{0.7}TiO₃ buffer layer 21 by a reactive co-evaporation, as shown in Figure 1D. The Y₁Ba₂Cu₃O₇₋ₓ oxide superconductor thin film 1 is grown so as to have a thickness of 5 nanometers or less which is suitable for a superconducting channel of a super-FET. A condition of forming the Y₁Ba₂Cu₃O₇₋ₓ oxide superconductor thin film 1 is the same as the Embodiment 1.

Then, as shown in Figure 1E, an gate insulating layer 7 of SrTiO₃ having a thickness of 15 nanometers is formed on a center portion of the Y₁Ba₂Cu₃O₇₋ₓ oxide superconductor thin film 1 by a reactive co-evaporation and a gate electrode 4 is formed of Au on the gate insulating layer 7 by a vacuum evaporation. A portion of the Y₁Ba₂Cu₃O₇₋ₓ oxide superconductor thin film 1 under the gate insulating layer 7 becomes a superconducting channel. The gate insulating layer 7 should have a thickness of 10 nanometers or more so as to prevent tunnel current. However, if the gate insulating layer 7 has a too large thickness, higher signal voltages are required to modulate and control superconducting current flowing through the superconducting channel. Therefore, the gate insulating layer 7 should have a thickness of 100 nanometers or less. A condition of forming the SrTiO₃ gate insulating layer 7 by a reactive co-evaporation is the same as Embodiment 1.

The gate insulating layer 7 can be formed of MgO, Si₃N₄ or BaₓSr₁₋ₓTiO₃ (0 ≤ x ≤ 1). The gate electrode 4 can also be formed of a noble metal such as Pt, Ag, polycrystalline silicon or an oxide superconductor.

Finally, as shown in Figure 1F, an oxide superconductor thin film is deposited on portions of the Y₁Ba₂Cu₃O₇₋ₓ oxide superconductor thin film 1 at the both sides of the gate electrode 4 by a reactive evaporation so as to form a superconducting source region 2 and superconducting drain region 3.

Properties of the super-FET of this embodiment manufactured as mentioned above were measured. In the super-FET of this embodiment, superconducting current I_{DS} was completely shut when a little high voltage V_{G} was applied to the gate electrode. Therefore, the super-FET in accordance with the present invention has small loss when the superconducting current is shut so as to have small consumption.

In addition, it was clear that the super-FETs of this embodiment had ideal current-voltage characteristics between the superconducting source and drain region.

The super-FET of this embodiment has a Y₁Ba₂Cu₃O₇₋ₓ oxide superconductor substrate, which is similar to a MESFET (Metal Semiconductor Field Effect Transistor) utilizing a GaAS substrate. This super-FET is favorably applied to a superconducting integrated circuit.

In this embodiment, only one super-FET according to the present invention has been described. However, the present invention is not limited to this embodiment. For example, the superconducting source region and the superconducting drain region may be gently connected to the superconducting channel so that superconducting current efficiently flows from the superconducting source region into the extremely thin superconducting channel and efficiently flows from the extremely thin superconducting channel to the superconducting drain region. In addition, the superconducting channel, the gate insulating layer and the gate electrode may have configurations so that they are self-aligned in the manufacturing process.

In the above mentioned embodiments, the oxide superconductor thin film can be formed of not only the Y-Ba-Cu-O compound oxide superconductor material, but also a high-T_{c} (high critical temperature) oxide superconductor material, particularly a high-T_{c} copper-oxide type compound oxide superconductor material, for example a Bi-Sr-Ca-Cu-O compound oxide superconductor material, and a Tl-Ba-Ca-Cu-O compound oxide superconductor material.

The invention has thus been shown and described with reference to the specific embodiments. However, it should be noted that the present invention is in no way limited to the details of the illustrated structures but converts and modifications may be made within the scope of the appended claims.

## Claims

1. A superconducting device comprising ;
a substrate (5) having a principal surface ;
a thin superconducting channel (10) formed of an oxide superconductor (1) over the principal surface of the substrate;
a superconducting source region (2) and a superconducting drain region (3) formed of an oxide superconductor over the principal surface of the substrate (5) at the both ends of the superconducting channel (10) which connects the superconducting source region and the superconducting drain region, so that superconducting current can flow through the superconducting channel (10) between the superconducting source region (2) and the superconducting drain region (3);
a gate electrode (4) on a gate insulator (7) disposed on the superconducting channel (10) for controlling the superconducting current flowing through the superconducting channel by a signal voltage applied to the gate electrode (4);
characterized in that it further comprises :
a first dielectric buffer layer (21), formed of BaₓSr₁₋ₓTiO₃ (0≤ x ≤1), under the superconducting source region (2), the superconducting channel (10) and the superconducting drain region (3), by which leak current is prevented when the superconducting channel is closed, and
a second buffer layer (20) of non-superconducting oxide, formed of Pr₁Ba₂Cu₃O_{7-y} thin film, having a similar crystal structure to that of an oxide superconductor between the first dielectric layer (21) and the principal surface of the substrate (5).

2. A superconducting device as claimed in claim 1, characterized in that the first dielectric layer (21) has a thickness of 10 to 30 nanometers.

3. A superconducting device as claimed in claim 1, characterized in that the second buffer layer (20) of non-superconducting oxide layer has a thickness of 10 to 30 nanometers.

4. A superconducting device as claimed in claim 1, characterized in that the oxide superconductor is formed of high-Tc (high critical temperature) oxide superconductor, particularly, formed of a high-Tc copper-oxide type compound oxide superconductor.

5. A superconducting device as claimed in claim 4, characterized in that the oxide superconductor is formed of oxide superconductor material selected from the group consisting of Y-Ba-Cu-O compound oxide superconductor material, a Bi-Sr-Ca-Cu-O compound oxide superconductor material, and a Tl-Ba-Ca-Cu-O compound oxide superconductor material.

6. A superconducting device as claimed in claim 1, characterized in that the substrate (5) is formed of a material selected from the group consisting of a MgO (100) substrate, a SrTiO₃ (100) substrate, a YSZ substrate and a semiconductor substrate having a insulating buffer layer on its surface.

7. A superconducting device as claimed in claim 1, characterized in that the substrate (5) is formed of Y₁Ba₂Cu₃O₇₋ₓ oxide superconductor single crystal.

## Patentansprüche

1. Supraleitende Einrichtung, aufweisend:
ein Substrat (5) mit einer Hauptfläche,
einen supraleitenden Kanal (10), der auf einem oxidischen Supraleiter (1) über der Hauptfläche des Substrats gebildet ist,
einen supraleitenden Source-Bereich (2) und einen supraleitenden Drain-Bereich (3), gebildet aus einem oxidischen Supraleiter über der Hauptfläche des Substrats (5) an beiden Enden des supraleitenden Kanals (10), welcher den supraleitenden Source-Bereich und den supraleitenden Drain-Bereich verbindet, so daß supraleitender Strom durch den supraleitenden Kanal (10) zwischen dem supraleitenden Source-Bereich (2) und dem supraleitenden Drain-Bereich (3) fließen kann,
eine Gate-Elektrode (4) auf einem Gate-Isolator (7), angeordnet auf dem supraleitenden Kanal (10) zum Steuern des supraleitenden Stroms, der durch den supraleitenden Kanal fließt, durch eine Signalspannung, die an die Gate-Elektrode (4) angelegt ist,
dadurch gekennzeichnet, daß sie außerdem aufweist:
eine erste dielektrische Pufferschicht (21), gebildet aus BaₓSr₁₋ₓTiO₃ (0 ≤ x ≤ 1) unter dem supraleitenden Source-Bereich (2), dem supraleitenden Kanal (10) und dem supraleitenden Drain-Bereich (3), durch welche Leckstrom verhindert wird, wenn der supraleitende Kanal geschlossen ist, und
eine zweite Pufferschicht (20) aus einem nicht-supraleitenden Oxid, gebildet aus einer Pr₁Ba₂Cu₃O_{7-y}-Dünnschicht mit einer ähnlichen Kristallstruktur wie diejenige des oxidischen Supraleiters zwischen der ersten dielektrischen Schicht (21) und der Hauptfläche des Substrats (5).

2. Supraleitende Einrichtung nach Anspruch 1, dadurch gekennzeichnet, daß die erste dielektrische Schicht (21) eine Dicke von 10 bis 30 Nanometern hat.

3. Supraleitende Einrichtung nach Anspruch 1, dadurch gekennzeichnet, daß die zweite Pufferschicht (20) aus der nichtsupraleitenden oxidischen Schicht eine Dicke von 10 bis 30 Nanometern hat.

4. Supraleitende Einrichtung nach Anspruch 1, dadurch gekennzeichnet, daß der oxidische Supraleiter aus einem oxidischen Supraleiter mit hoher T_{c} (hohe kritische Temperatur) gebildet ist, insbesondere aus einem supraleitenden Kupferoxid-Verbundoxid.

5. Supraleitende Einrichtung nach Anspruch 4, dadurch gekennzeichnet, daß der oxidische Supraleiter aus einem oxidischen Supraleiter gebildet ist, der aus der Gruppe ausgewählt ist, die aus supraleitendem Y-Ba-Cu-O-Verbundoxid, einem supraleitenden Bi-Sr-Ca-Cu-O-Verbundoxid und einem supraleitenden Tl-Ba-Ca-Cu-O-Verbundoxid besteht.

6. Supraleitende Einrichtung nach Anspruch 1, dadurch gekennzeichnet, daß das Substrat (5) aus einem Material gebildet ist, das aus der Gruppe gewählt ist, die aus einem MgO(100)-Substrat, einem SrTiO₃(100)-Substrat, einem YSZ-Substrat und einem Halbleitersubstrat mit einer isolierenden Pufferschicht auf seiner Oberfläche besteht.

7. Supraleitende Einrichtung nach Anspruch 1, dadurch gekennzeichnet, daß das Substrat (5) aus einem oxidischen supraleitenden Y₁Ba₂Cu₃O₇₋ₓ-Einkristall gebildet ist.

## Revendications

1. Dispositif supraconducteur comprenant :
un substrat (5) présentant une surface principale;
un canal supraconducteur mince (10) constitué d'un oxyde supraconducteur (1) sur la surface principale du substrat ;
une zone de source supraconductrice (2) et une zone de drain supraconductrice (3), constituées d'un oxyde supraconducteur sur la surface principale du substrat (5) au niveau des deux extrémités du canal supraconducteur (10) qui connecte la zone de source supraconductrice et la zone de drain supraconductrice, de sorte qu'un courant supraconducteur peut circuler à travers le canal supraconducteur (10) entre la zone de source supraconductrice (2) et la zone de drain supraconductrice (3) ;
une électrode de grille (4) située sur un isolateur de grille (7) disposée sur le canal supraconducteur (10) pour commander la circulation du courant supraconducteur dans le canal supraconducteur par une tension de signal appliquée à l'électrode de grille (4) ;
caractérisé en ce qu'il comprend, de plus, :
une première couche tampon diélectrique (21), constituée de BaₓSr₁₋ₓTiO₃ (0 ≤ x ≤ 1), sous la zone de source supraconductrice (2), le canal supraconducteur (10) et la zone de drain supraconductrice (3) , par laquelle un courant de fuite est évité lorsque le canal supraconducteur est fermé , et
une seconde couche tampon (20) d'oxyde non supraconducteur , formée d'une couche mince de Pr₁Ba₂Cu₃O_{7-y} , présentant une structure cristalline similaire à celle d'un oxyde supraconducteur, placée entre la première couche diélectrique (21) et la surface principale du substrat (5).

2. Dispositif supraconducteur selon la revendication 1, caractérisé en ce que la première couche diélectrique (21) présente une épaisseur de 10 à 30 nanomètres.

3. Dispositif supraconducteur selon la revendication 1, caractérisé en ce que la seconde couche tampon (20) de la couche d'oxyde non supraconducteur présente une épaisseur de 10 à 30 nanomètres.

4. Dispositif supraconducteur selon la revendication 1, caractérisé en ce que l'oxyde supraconducteur est formé d'un oxyde supraconducteur à température critique élevée (Tc élevée), particulièrement d'un supraconducteur d'oxyde composé de type oxyde de cuivre à Tc élevée.

5. Dispositif supraconducteur selon la revendication 4, caractérisé en ce que l'oxyde supraconducteur est formé d'un matériau en oxyde supraconducteur sélectionné dans le groupe constitué d'un matériau supraconducteur d'oxyde composé Y-Ba-Cu-O, d'un matériau supraconducteur d'oxyde composé Bi-Sr-Ca-Cu-O et d'un matériau supraconducteur d'oxyde composé Tl-Ba-Ca-Cu-O.

6. Dispositif supraconducteur selon la revendication 1 , caractérisé en ce que le substrat (5) est constitué d'un matériau sélectionné dans le groupe constitué d'un substrat de MgO (100) , d'un substrat de SrTiO₃ (100) , d'un substrat de YSZ et d'un substrat semiconducteur comportant une couche tampon isolante sur sa surface .

7. Dispositif supraconducteur selon la revendication 1, caractérisé en ce que le substrat (5) est formé d'un monocristal d'oxyde supraconducteur de Y₁Ba₂Cu₃O₇₋ₓ.
